# EUROPEAN PATENT SPECIFICATION

(11) **EP 4 145 668 B1**
(45) Date of publication and mention of the grant of the patent: **11.11.2026**
(21) Application number: 22193493.8
(22) Date of filing: 01.09.2022
(51) Int. Cl.: H02J 7/65, H02J 50/10, H02J 50/00

(54) **WIRELESS CHARGER WITH VENTING SYSTEM**
DRAHTLOSES LADEGERÄT MIT ENTLÜFTUNGSSYSTEM
CHARGEUR SANS FIL AVEC SYSTÈME DE VENTILATION

(30) Priority: 02.09.2021 US 202163240162 P
(43) Date of publication of application: 08.03.2023
(73) Proprietor: Molex, LLC, Lisle, IL 60532 (US)
(72) Inventor: SETH, Christian, Zossen (DE); GRIESCHE, Alexander, Zossen (DE); HELDT, Ronald, Gross Machnow (DE); REIF, Reinhold, Schwaig (DE)
(74) Representative: Ter Meer und Partner mbB

(56) References cited:
- WO-A1-2021/109803
- CN-A- 113 036 838
- US-A1- 2019 223 329
- US-A1- 2021 185 854

## Description

### TECHNICAL FIELD

This disclosure relates to the field of wireless charging, more specifically to wireless charging of a mobile device in a vehicle.

### DESCRIPTION OF RELATED ART

Wireless charging is known to be an effective and simple way, at least for the consumer, to charge a mobile device. A conventional wireless charger includes a housing and a transmit (Tx) coil within the housing. The Tx coil is configured to couple to a receive (Rx) coil of a mobile device when placed adjacent the Tx coil. When the Tx and Rx coils are coupled together, a time-varying magnetic field is provided on the Rx coil that induces a current, which, in turn, can charge a battery in the mobile device.
US 2021/185854 A1 discloses a wireless charging device including a housing, an induction coil, a ferrite, a printed circuit board (PCB), and a fan. The housing includes a first surface and a second surface, a protrusion is disposed on the first surface, and the protrusion is configured to: support a to-be-charged device, and leave a gap between the to-be-charged device and the first surface when the to-be-charged device is installed on the wireless charging device. At least one first air guiding opening and at least one second air guiding opening are disposed on the housing. When the fan runs, the first air guiding opening, the fan, and the second air guiding opening form an air duct that passes through the ferrite and the PCB.
CN 113 036 838 A discloses a wireless charger which comprises a shell, a circuit board assembly and a heat conduction structure. The shell is provided with a first air inlet and a first air outlet; a heat dissipation air channel which is communicated with the first air inlet and the first air outlet and is located in the shell is formed between the first air inlet and the first air outlet The circuit board assembly is located in the heat dissipation air channel. The heat conduction structure comprises a contact part and a connection part which are connected with each other. At least part of the contact part extends out of the outer surface of the shell. The contact part is used for contacting with equipment to be charged. The connection part is located in the shell and contacts with the heat dissipation air channel. The contact part, the outer surface of the shell and the to-be-charged equipment are matched to form a ventilation air channel. The ventilation air channel is communicated with the heat dissipation air channel.
WO 2021/109803 A1 discloses a wireless charging device. The wireless charging device comprises a housing, a coil module, a fan and a circuit assembly. The housing is provided with a first air inlet, a second air inlet and an air outlet. The coil module is located inside the housing. The fan is located inside the housing and is arranged spaced apart from the coil module. The circuit assembly is located on the side of the fan that is away from the coil module, and there is a gap between the circuit assembly and the fan. During operation, the fan drives an air flow to enter the housing from the first air inlet and flow out from the air outlet, so that a first air channel flowing through the coil module is formed; and drives an air flow to enter the housing from the second air inlet and flow out from the air outlet, so that a second air channel flowing through the gap is formed.
US 2019/223329 A1 discloses a wireless charging device comprising a first housing, which includes a first surface facing a first direction and a second surface facing a second direction opposite to the first direction, and includes at least one hole; a second housing arranged on the second surface of the first housing in the second direction; a coil unit arranged between the first housing and the second housing and configured to transmit power to an external device; a shielding member arranged adjacent to the coil unit and including at least one hole; and a fan arranged adjacent to the coil unit and configured to rotate.

### SUMMARY

This section provides a general summary of the disclosure and is not a comprehensive disclosure of its full scope or all of its features.

Exemplary embodiments are disclosed of wireless charging modules configured to include cooling features. In an exemplary embodiment, a wireless charging module includes a housing configured to support at least one coil module therein. The housing includes an upper housing portion and a lower housing portion. The upper housing portion includes at least one vent. The lower housing portion includes at least one vent. One or more ducts are provided within the housing. The one or more ducts are in communication with the at least one vent of the upper housing portion and the at least one vent of the lower housing portion. An airflow path is defined from the at least one vent of the upper housing portion through the one or more ducts to the at least one vent of the lower housing portion for allowing an air flow internally within the housing generally around and/or adjacent at least a portion of the at least one coil module supported within the housing. The at least one vent of the upper housing portion comprises at least one outlet configured to be selectively in communication with a cool air supply via the one or more ducts. Air from the cool air supply is routable through the one or more ducts to the at least one outlet of the upper housing portion from which the air is dischargeable to thereafter flow along at least one surface of a mobile device that has been placed along the upper housing portion for wireless charging. The at least one outlet is in communication with at least one valve via the one or more ducts. The at least one valve is configured to provide the at least one outlet with selective access to the cool air supply.

In in one or more embodiments, the upper housing portion may include a plurality of upwardly protruding portions spaced apart along the upper housing portion.

In in one or more embodiments, the upwardly protruding portions may be configured to allow air to pass underneath a mobile device that has been placed atop the upwardly protruding portions for wireless charging.

In in one or more embodiments, the wireless charging module may further comprise at least one fan in communication with the one or more ducts via the at least one vent of the lower housing portion.

In in one or more embodiments, the at least one fan may be configured to be operable for generating an air flow into the at least one vent of the upper housing portion through the one or more ducts to the at least one vent of the lower housing portion.

In in one or more embodiments, the one or more ducts may comprise a plurality of ducts provided within the housing.

In in one or more embodiments, the at least one vent of the upper housing portion may comprise first and second vents in communication with the plurality of ducts.

In in one or more embodiments, the first and second vents may be spaced apart from each other along the upper housing portion so as to be respectively adjacent opposite first and second end portions of a mobile device when the mobile device is placed along the upper housing portion for wireless charging.

In in one or more embodiments, the upper housing portion may include a plurality of ribs spaced apart along and upwardly protruding from the upper housing portion.

In in one or more embodiments, the at least one vent of the lower housing portion may comprise at least one air outlet.

In in one or more embodiments, the at least one vent of the upper housing portion may comprise first and second air inlets in communication with the one or more ducts, the first and second air inlets spaced apart from each other along the upper housing portion so as to be respectively adjacent opposite first and second end portions of a mobile device that has been placed atop the ribs for wireless charging.

In in one or more embodiments, the ribs may be configured to allow air to pass underneath the mobile device and then be drawn into the first and second air inlets through the one or more ducts to the at least one air outlet of the lower housing portion.

In in one or more embodiments, the wireless charging module may further comprise at least one fan in communication with the one or more ducts via the at least one air outlet of the lower housing portion.

In in one or more embodiments, the at least one fan may be configured to be operable for drawing air from underneath the mobile device between pairs of adjacent ribs into the first and second air inlets through the one or more ducts to the at least one air outlet of the lower housing portion.

In in one or more embodiments, the at least one vent of the upper housing portion may further comprise at least one inlet downstream from the at least one outlet.

In in one or more embodiments, the at least one inlet may be configured for receiving air discharged from the at least one outlet after flowing along the at least one surface of the mobile device

In in one or more embodiments, the wireless charging module may further comprise at least one fan in communication with the at least one inlet via the one or more ducts

In in one or more embodiments, the at least one fan may be configured to be operable for drawing or pulling air into the at least one inlet.

In in one or more embodiments, the wireless charging module may be configured to allow the at least one outlet to be selectively in communication with an air conditioning system of a vehicle in which the wireless charging module is being used.

In in one or more embodiments, the cool air supply may comprise at least one fan in communication with the at least one outlet via the one or more ducts.

In in one or more embodiments, the wireless charging module may further comprise at least one temperature sensor configured to be operable for determining a temperature of the mobile device that has been placed along the upper housing portion for wireless charging module.

In in one or more embodiments, the wireless charging module may be configured to determine whether the temperature of the mobile device is increasing and needs additional cooling.

In in one or more embodiments, the wireless charging module may be configured, in response to determine that the temperature of the mobile device is increasing and needs additional cooling, to route air from the cool air supply through the one or more ducts to the at least one outlet from which the air is discharged to flow along at least one surface of the mobile device.

In in one or more embodiments, the wireless charging module may be configured to, based on one or more predetermined conditions, route air from the cool air supply through the one or more ducts to the at least one outlet from which the air is discharged to flow along at least one surface of a mobile device that has been placed along the upper housing portion for wireless charging.

In in one or more embodiments, the one or more predetermined conditions may include an excess temperature alert received from the mobile device; and/or a determination that additional cooling is desirable based on an amount of power being provided to a receive coil of the mobile device.

In in one or more embodiments, the upper and lower housing portions may be configured to be coupled together such that an interior compartment for the at least one coil module is cooperatively defined between the upper and lower housing portions and such that the one or more ducts are disposed generally around a least a portion of the at least one coil module.

In in one or more embodiments, the wireless charging module may further comprise a substrate between the at least one coil module and the upper housing portion.

In in one or more embodiments, the substrate may include at least one aperture aligned with the at least one vent of the upper housing portion to thereby allow the at least one vent of the upper housing portion to communicate with the one or more ducts via the at least one aperture without obstruction from the substrate.

In in one or more embodiments, the at least one vent of the upper housing portion may comprise at least one outlet.

In in one or more embodiments, the one or more ducts may comprise at least one side duct in communication with the at least one outlet.

In in one or more embodiments, the at least one side duct may be cooperatively defined by an upper channel of the upper housing portion and a lower channel of the lower housing portion.

In in one or more embodiments, the wireless charging module may further comprise a substrate between the at least one coil module and the upper housing portion.

In in one or more embodiments, the substrate may include at least one slot aligned with the upper channel and the lower channel such that the substrate does not obstruct the at least one side duct.

In in one or more embodiments, air may be routable through the at least one side duct to the at least one outlet from which the air is dischargeable to thereafter flow along at least one surface of a mobile device that has been placed along the upper housing portion for wireless charging.

In in one or more embodiments, the housing may be configured to support first and second coil modules therein that are operable for respectively charging first and second mobile devices when placed along the upper housing portion respectively above the first and second coil modules.

In in one or more embodiments, the one or more ducts may comprises at least one side duct substantially centrally positioned along the upper housing portion above the first and second coil modules.

In in one or more embodiments, the at least one vent of the upper housing portion may comprise first and second outlets in communication with the at least one side duct.

In in one or more embodiments, air may be routable through the at least one side duct to the first and second outlets from which the air is dischargeable to thereafter flow along surfaces of the respective first and second mobile devices that have been between placed along the upper housing portion respectively above the first and second coil modules and along opposite first and second sides of the at least one side duct.

In in one or more embodiments, the housing may be configured to support first and second coil modules therein that are operable for respectively charging first and second mobile devices when placed along the upper housing portion respectively above the first and second coil modules.

In in one or more embodiments, the one or more ducts may comprise first and second air ducts defined generally around and/or adjacent at least a portion of the first coil module supported within the housing.

In in one or more embodiments, the one or more ducts may comprise third and fourth air ducts defined generally around and/or adjacent at least a portion of the second coil module supported within the housing.

In in one or more embodiments, the at least one vent of the upper housing portion may comprise first and second air inlets spaced apart along the upper housing portion so as to be adjacent opposite end portions of the first mobile device when the first mobile device is placed along the upper housing portion above the first coil module.

In in one or more embodiments, the third and fourth air inlets may be spaced apart along the upper housing portion so as to be adjacent opposite end portions of the second mobile device when the second mobile device is placed along the upper housing portion above the second coil module.

In in one or more embodiments, the at least one vent of the lower housing portion may comprise at least one of a first air outlet in communication with the first and second air inlets via the respective first and second air ducts; and/or a second air outlet in communication with the third and fourth air inlets via the respective third and fourth air ducts.

In in one or more embodiments, the wireless charging module may further comprise a first fan in communication with the first and second air ducts via the first air outlet of the bottom housing portion.

In in one or more embodiments, the first fan may be configured to be operable for generating an air flow into the first and second air inlets of the upper housing portion through the first and second air ducts generally around and/or adjacent the at least a portion of the first coil module supported within the housing to the first air outlet of the lower housing portion.

In in one or more embodiments, the wireless charging module may further comprise a second fan in communication with the third and fourth air ducts via the second air outlet of the bottom housing portion.

In in one or more embodiments, the second fan may be configured to be operable for generating an air flow into the third and fourth air inlets of the upper housing portion through the third and fourth air ducts generally around and/or adjacent the at least a portion of the second coil module supported within the housing to the second air outlet of the lower housing portion.

Further areas of applicability will become apparent from the description provided herein. The description and specific examples in this summary are intended for purposes of illustration only and are not intended to limit the scope of the present disclosure.

### DRAWINGS

The present application is illustrated by way of example and not limited in the accompanying figures in which like reference numerals indicate similar elements and in which:
FIG. 1 is an exploded perspective view of a wireless charging module according to an exemplary embodiment of the present disclosure.
FIG. 2 is a perspective view illustrating the transmit (Tx) coil modules assembled to and supported by the lower housing portion of the wireless charging module shown in FIG. 1.
FIG. 3 is a cross-sectional view of the wireless charging module shown in FIG. 1 after being assembled. Arrows represent a cooling airflow across the upper housing portion and internally within ductwork (*e.g.,* a plurality of air passageways or ducts, *etc.*) provided in (*e.g.,* integrally defined by, *etc.*) the housing generally around and/or adjacent at least a portion of at least one coil module supported within the housing.
FIG. 4 is a schematic diagram of a wireless charging module including a valve and fan configured to provide access to cool air according to an exemplary embodiment of the present disclosure.

### DETAILED DESCRIPTION

The detailed description that follows describes exemplary embodiments and the features disclosed are not intended to be limited to the expressly disclosed combination(s). Therefore, unless otherwise noted, features disclosed herein may be combined together to form additional combinations that were not otherwise shown for purposes of brevity.

15 Watt (15W) automotive wireless chargers are used for charging mobile devices (*e.g*., mobile phones, *etc.*) in vehicles. Advantageously, 15W automotive wireless chargers allow for faster charging and shorter charging times of mobile devices. But the faster charging and reduced charging times may be associated with overheating and increased temperatures of the 15W wireless chargers and mobile devices. After recognizing the above heating concerns, exemplary embodiments were developed and/or are disclosed herein of wireless charging modules configured to include cooling features.

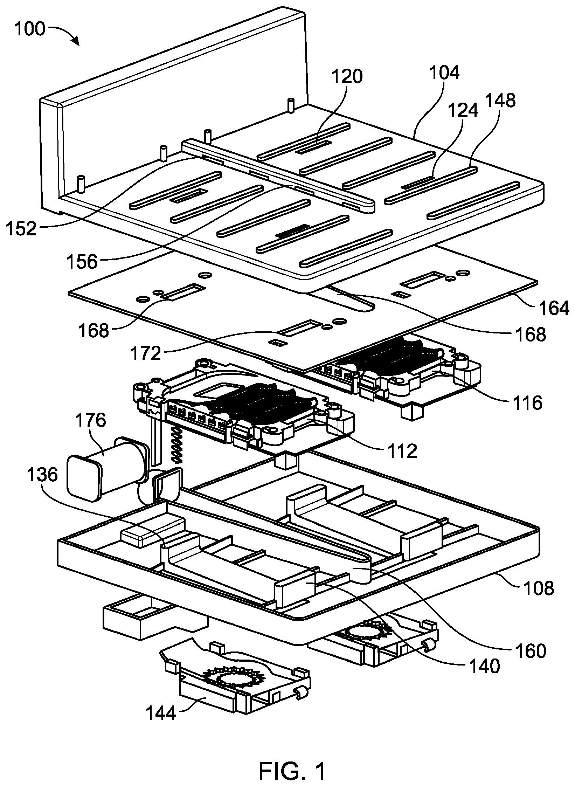

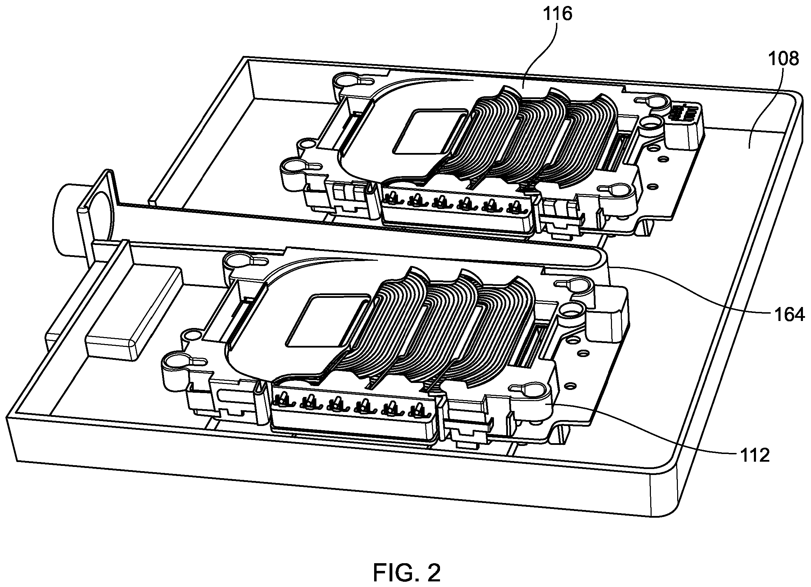

With reference now to the figures, FIGS. 1 through 3 illustrate a wireless charging module 100 according to an exemplary embodiment of the present disclosure. The wireless charging module 100 includes upper and lower housing portions 104, 108 configured to be coupled together such that an interior compartment is cooperatively defined between the upper and lower housing portions 104, 108. The housing interior compartment is configured for supporting first and second coil modules 112, 116 therein. See, for example, FIG. 2 in which the first and second coil modules 112, 116 are shown assembled to and supported by the lower housing portion 108 of the wireless charging module 100.

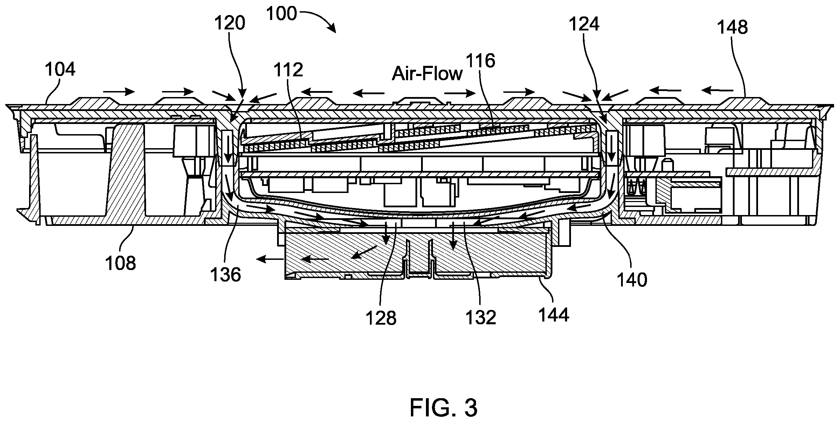

As shown in FIG. 3, the wireless charging module 100 is configured to provide a cooling airflow (as indicated by arrows) across the upper housing portion 104 (*e.g.,* to flow across at least one surface of a mobile device placed on the upper housing portion 104, *etc.*) and internally within the housing generally around and/or adjacent at least portions of the first and second coil modules 112, 116. As shown in FIG. 3, the upper housing portion 104 includes (*e.g*., integrally defines, *etc.*) air inlets or vents 120, 124. And the lower housing portion 108 includes (*e.g.,* integrally defines, *etc.*) air outlets or vents 128, 132. Air passageways or ducts 136, 140 are provided within (*e.g.,* integrally defined by, *etc.*) the housing that are in communication with the air inlets 120, 124 and the air outlets 128, 132. At least one fan 144 is in communication with the ducts 136, 140 via the air outlets 128, 132. The fan 144 is operable for generating an air flow (represented by arrows) into the air inlets 120, 124 through the ducts 136, 140 generally around the first and second coil modules 112, 116 to the air outlets 128, 132.

In this exemplary embodiment, the upper housing portion 104 includes (*e.g*., integrally defines, injection molded, *etc.*) upwardly protruding portions 148 spaced apart along the upper housing portion 104 as shown in FIGS. 1 and 3. The upwardly protruding portions 148 are configured to allow air to pass underneath a mobile device that has been placed atop the upwardly protruding portions 148 for wireless charging by the wireless charging module 100, and thereafter be drawn into the air inlets or vents 120, 124 of the upper housing portion 104.

By way of example, the upwardly protruding portions 148 may comprise ribs that extend laterally across or along a width of the upper surface portion 104 as shown in FIG. 1. The ribs have a generally trapezoidal cross-sectional shape or profile (*e.g.,* isosceles trapezoid including congruent base angles and congruent non-parallel sides, *etc.*) as shown in FIG. 3. The ribs may have a height of about 1 millimeter. But this 1 millimeter height dimension and trapezoidal shape for the ribs are example in nature and do not limit the scope of the present disclosure. In alternative embodiments, a wireless charging module may include an upper housing portion with upwardly protruding portions that are configured differently (*e.g.,* differently shaped, different dimensions, *etc.*) or without any upwardly protruding portions.

By way of background, 15 Watt (15W) automotive wireless chargers operate at high z gap distances that may result in poor coupling factors (k). The coupling factor indicates how much magnetic flux from the transmit (Tx) coil reaches the receive (Rx) coil. The magnetic flux interaction takes place in the air gap between the Tx and Rx coils. The value of the coupling factor ranges from 0 to 1. A coupling factor of 0 refers to decoupled coils. A coupling factor of 1 refers to a perfect coupling in which all magnetic flux from the transmitter coil penetrates to the receiver coil.

As just noted, the wireless charging module 100 includes upwardly protruding portions 148 along the wireless charging module's upper housing portion 104. The upwardly protruding portions 148 are configured to create airflow channels between adjacent pairs of the upwardly protruding portions 148 underneath a mobile device that has been placed atop the upwardly protruding portions 148 for wireless charging. By elevating the mobile device above the upper housing portion 104 to create the airflow channels underneath the mobile device, the upwardly protruding portions 148 increase the z-gap distance between the receive (Rx) coil of the mobile device and the transmit (Tx) coils of the wireless charging module 100. Accordingly, the upwardly protruding portions 148 thus provide a counterintuitive way of providing additional cooling for the mobile device. And the additional cooling may advantageously allow for wireless charging of the mobile device at a higher power level without overheating of the mobile device. This exemplary configuration for the wireless charging module may also provide a generally symmetrical airflow across at least one surface of the mobile device along opposite sides of a receive coil of the mobile device while avoiding interference with the transmit (Tx) coils of the wireless charging module 100.

As shown in FIG. 3, the upper and lower housing portions 104, 108 cooperatively define the air passageways or ducts 136, 140 in communication with the air inlets or vents 120, 124 of the upper housing portion 104 and the air outlets or vents 128, 132 of the lower housing portion 108. In this exemplary embodiment, the upper housing portion 104 includes or integrally defines upper ducts that engage with lower ducts included within or integrally defined by the lower housing portion 108.

With continued reference to FIG. 1, the upper housing portion 104 also includes a plurality of vents or outlets 152 in communication with a side air passageway or side duct. Air is routable through the side duct to the outlets 152 from which the air is dischargeable to thereafter flow along at least one surface of a mobile device that has been placed along the upper housing portion 104 for wireless charging. In this exemplary embodiment, the side duct is formed by a combination of an upper or top channel 156 of the upper housing portion 104 and a lower or bottom channel 160 of the lower housing portion 108.

In this exemplary embodiment, the side duct is positioned substantially centrally along the upper surface portion 104 above the first and second coil modules 112, 116. The side duct is intended to provide cool air alongside two mobile devices placed along opposite sides of the side duct. Accordingly, outlets are along each of the opposite sides of the side duct 104 for discharging air alongside each of the two mobile devices. In alternative embodiments including a single wireless charger (instead of the dual wireless charger design shown in FIG. 1), the side duct could be positioned along or adjacent a side edge of the upper housing portion. Depending on the configuration of the upper housing portion or top panel 104, the side duct may have a simpler or more complex shape so as to position cool air along one or more sides of a mobile device.

The wireless charging module 100 further comprises a substrate 164 (FIG.1) between the first and second coil modules 112, 116 and the upper housing portion 104. The substrate 164 includes at least one slot 168 aligned with the upper channel 156 and the lower channel 160 such that the substrate 164 does not obstruct the side duct. The substrate 164 also includes four apertures or openings 168, 172 aligned with the four air inlets or vents 120, 124 of the upper housing portion 104. The substrate's apertures or openings 168, 172 allow the air inlets or vents 120, 124 of the upper housing portion 104 to communicate with the ducts 136, 140 provided in (*e.g.*, integrally defined by, injection molded, *etc.*) the lower housing portion 108 without obstruction from the substrate 164.

Also shown in FIG. 1 is a valve 176 configured to provide access to cool air that can flow through the side duct to the outlets or vents 152 along the upper housing portion 104. The cool air can be provided by the vehicle's air conditioning (AC) system if the system is turned on and can be controlled by the valve 176. In general, the valve 176 should be sufficient if the AC system has sufficient pressure to force cool air through the outlets or vents 152 along the upper housing portion 104 of the wireless charging module 100. Conversely, if the pressure differential is insufficient, then the valve 176 can be replaced by a fan that creates sufficient pressure differential to force cool air out of the one or more outlets or vents 152.

As shown in FIGS. 1, 2, and 3, each coil module 112, 116 includes three transmit (Tx) coils placed in an overlapping arrangement in which at least a portion of a first coil overlaps at least a portion of a second coil and at least a portion of the second coil overlaps at least a portion of a third coil. In this example, the three transmit coils are overlappingly arranged in such a way to resemble a scaly structure (*e.g.,* transmit coils resemble scales lying over each other, *etc.*) or a structure resembling three fallen dominoes. But the transmit coils and coil topologies of the coil modules 112, 116 are examples only. Alternative embodiments may include wireless charging modules configured differently, *e.g.,* with more or less than two coil modules (*e.g.,* a single coil module, *etc.*)*,* with one or more coil modules with different coil topologies (*e.g.,* non-overlapping transmit coils, *etc*.)*,* with one or more coil modules with more or less than three transmit coils, with differently configured transmit coils (*e.g.,* more or less coil windings, *etc.*), *etc.*

For example, another exemplary embodiment of a wireless charging module may include at least one transmit coil(s) having a center opening devoid of material such that the center opening remains open to allow air flow through the center of the transmit coil(s) for additional cooling.

By way of further example, another exemplary embodiment of a wireless charging module includes a single coil module for wirelessly charging a single mobile device. In such exemplary embodiment, the cooling features disclosed herein are configured for cooling a single mobile device that is being charged by the wireless charging module. For example, the upper housing portion includes two air inlets or vents spaced apart so as to be positioned adjacent opposite first and second end portions of the single mobile device. The lower housing portion includes a single air outlet or vent in communication with the two air inlets or vents of the upper housing portion via ductwork (*e.g.,* one or more air passageways or ducts, *etc.*) provided in (*e.g.,* integrally defined by, *etc*.) the housing. The wireless charging module also includes one fan in communication with the ductwork via the single air outlet or vent of the lower housing portion. The fan is operable for generating an air flow into the two air inlets or vents of the upper housing portion through the ductwork around at least a portion of the single coil module to the single air outlet or vent of the lower housing portion.

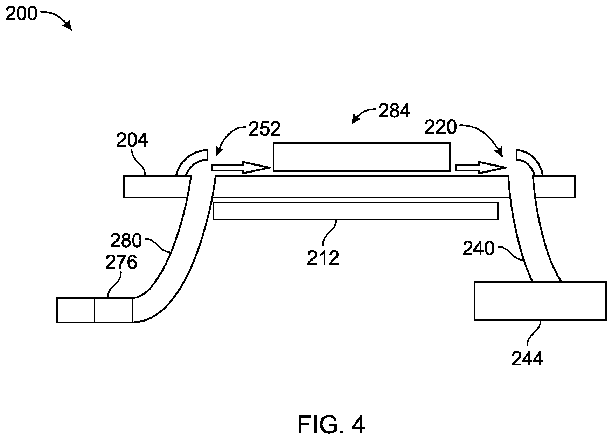

FIG. 4 is a schematic diagram of a wireless charging module 200 wherein an additional cooling source is provided. The cool air can be provided by the vehicle's air conditioning (AC) system if the system is turned on and can be controlled by a valve or fan. In general, a valve 276 should be sufficient if the AC system has sufficient pressure to force cool air through one or more outlets or vents 252 along the upper surface portion 204 of the wireless charging module 200. Conversely, if the pressure differential is insufficient, then the valve can be replaced by a fan that creates sufficient pressure differential to force cool air out of the one or more outlets or vents 252.

As shown in FIG. 4, the wireless charging module 200 includes the valve 276 and the fan 244 to provide access to cool air. In this exemplary embodiment, cool air is routed through the side air passageway or duct 280 within the wireless charging module to the outlet or vent 252 of the upper housing portion 204. Cool air discharged from the outlet or vent 252 is directed, deflected, or otherwise routed to flow along a surface of a mobile device 284 placed on the upper housing portion 204. After the cool air flows along the surface of the mobile device 284, the air is routed, flows, or otherwise makes its way (*e.g.,* drawn or pulled via the fan 244, *etc.*) to an inlet or vent 220 of the upper housing portion 204 into another air passageway or duct 240 within the wireless charging module 200. The fan 244 is operable for drawing or pulling air into the inlet or vent 220 and through the duct 240.

The cool air can be provided with or without the fan 244. And the fan 244 can pull air into the inlet or vent 220 through the duct 240 with or without the valve 276 allowing cool air to exit the wireless charging module 200 via one or more outlets or vents.

In an exemplary embodiment, a temperature sensor can be provided that is configured to be operable for determining a temperature of the mobile device 284 that has been placed along the upper housing portion 204 for wireless charging. In this example, the wireless charging module 200 may be configured to determine whether the temperature of the mobile device 284 is increasing and needs additional cooling. And in response to determining that the mobile device is increasing and needs additional cooling, the wireless charging module may to engage the valve 276 to thereby route air from the cool air supply through the duct 280 to the outlet or vent 252 from which the air is discharged to flow along at least one surface of the mobile device 284. Additionally, or alternatively, the wireless charging module 200 may be configured to engage either or both the valve 276 and the fan 244 based on one or more predetermined conditions, to thereby route air from the cool air supply through the duct 280 to the outlet or vent 252 from which the air is discharged to flow along at least one surface of the mobile device 284. The one or more predetermined conditions may include an excess temperature alert received from the mobile device; and/or a determination that additional cooling is desirable based on an amount of power being provided to a receive coil of the mobile device

Accordingly, disclosed herein are exemplary embodiments of wireless charging modules configured to include cooling features. Also disclosed are exemplary methods of operating a wireless charging module including cooling one or more coil modules of the wireless charging module and/or cooling one or more mobile devices placed on the wireless charging module for wireless charging.

The disclosure provided herein describes features in terms of preferred and exemplary embodiments thereof. Numerous other embodiments, modifications and variations within the scope of the appended claims will occur to persons of ordinary skill in the art from a review of this disclosure

## Claims

1. A wireless charging module comprising:
a housing (104, 108) configured to support at least one coil module (112, 116) therein, the housing including an upper housing portion (104) and a lower housing portion (108), the upper housing portion (104) including at least one vent (120, 124), the lower housing portion (108) including at least one vent (128, 132); and
one or more ducts (136, 140) provided within the housing (104, 108) and in communication with the at least one vent (120, 124) of the upper housing portion (104) and the at least one vent (128, 132) of the lower housing portion (108), whereby an airflow path is defined from the at least one vent (120, 124) of the upper housing portion (104) through the one or more ducts (136, 140) to the at least one vent (128, 132) of the lower housing portion (108) for allowing an air flow internally within the housing (104, 108) generally around and/or adjacent at least a portion of the at least one coil module (112, 116) supported within the housing (104, 108),
wherein the at least one vent (120, 124) of the upper housing portion (104) comprises at least one outlet configured to be selectively in communication with a cool air supply via the one or more ducts (136, 140), whereby air from the cool air supply is routable through the one or more ducts (136, 140) to the at least one outlet of the upper housing portion from which the air is dischargeable to thereafter flow along at least one surface of a mobile device that has been placed along the upper housing portion (104) for wireless charging, and
wherein the at least one outlet is in communication with at least one valve (176) via the one or more ducts (136, 140), the at least one valve (176) configured to provide the at least one outlet with selective access to the cool air supply.

2. The wireless charging module of claim 1, wherein the upper housing portion (104) includes a plurality of upwardly protruding portions (148) spaced apart along the upper housing portion (104), whereby the upwardly protruding portions (148) are configured to allow air to pass underneath a mobile device that has been placed atop the upwardly protruding portions (148) for wireless charging.

3. The wireless charging module of claim 1 or 2, further comprising at least one fan (144) in communication with the one or more ducts (136, 140) via the at least one vent (128, 132) of the lower housing portion (108), the at least one fan (144) configured to be operable for generating an air flow into the at least one vent (120, 124) of the upper housing portion (104) through the one or more ducts (136, 140) to the at least one vent (128, 132) of the lower housing portion (108).

4. The wireless charging module of any one of claims 1 to 3, wherein:
the one or more ducts (136, 140) comprise a plurality of ducts provided within the housing;
the at least one vent (120, 124) of the upper housing portion (104) comprises first and second vents in communication with the plurality of ducts (136, 140); and
the first and second vents are spaced apart from each other along the upper housing portion (104) so as to be respectively adjacent opposite first and second end portions of a mobile device when the mobile device is placed along the upper housing portion (104) for wireless charging.

5. The wireless charging module of any one of the preceding claims, wherein:
the upper housing portion (104) includes a plurality of ribs spaced apart along and upwardly protruding from the upper housing portion (104);
the at least one vent of the lower housing portion (108) comprises at least one air outlet (128, 132);
the at least one vent of the upper housing portion (104) comprises first and second air inlets (120, 124) in communication with the one or more ducts (136, 140), the first and second air inlets (120, 124) spaced apart from each other along the upper housing portion (104) so as to be respectively adjacent opposite first and second end portions of a mobile device that has been placed atop the ribs for wireless charging; and
the ribs are configured to allow air to pass underneath the mobile device and then be drawn into the first and second air inlets (120, 124) through the one or more ducts (136, 140) to the at least one air outlet (128, 132) of the lower housing portion (108).

6. The wireless charging module of claim 5, wherein:
the wireless charging module (100) further comprises at least one fan (148) in communication with the one or more ducts (136, 140) via the at least one air outlet (128, 132) of the lower housing portion (108); and
the at least one fan (148) is configured to be operable for drawing air from underneath the mobile device between pairs of adjacent ribs into the first and second air inlets (120, 124) through the one or more ducts (136, 140) to the at least one air outlet (128, 132) of the lower housing portion (108).

7. The wireless charging module of claim 1, wherein:
the at least one vent of the upper housing portion (104) further comprises at least one inlet downstream from the at least one outlet, whereby the at least one inlet is configured for receiving air discharged from the at least one outlet after flowing along the at least one surface of the mobile device; and
the wireless charging module (100) further comprises at least one fan (148) in communication with the at least one inlet via the one or more ducts (136, 140), whereby the at least one fan (148) is configured to be operable for drawing or pulling air into the at least one inlet.

8. The wireless charging module of any one of the preceding claims, wherein:
the wireless charging module (100) is configured to allow the at least one outlet to be selectively in communication with an air conditioning system of a vehicle in which the wireless charging module (100) is being used; and/or
the cool air supply comprises at least one fan (148) in communication with the at least one outlet via the one or more ducts (136, 140).

9. The wireless charging module of any one of the preceding claims, wherein:
the wireless charging module (100) further comprises at least one temperature sensor configured to be operable for determining a temperature of the mobile device that has been placed along the upper housing portion (104) for wireless charging; and/or
the wireless charging module (100) is configured to:
determine whether the temperature of the mobile device is increasing and needs additional cooling; and
in response to determining that the mobile device is increasing and needs additional cooling, route air from the cool air supply through the one or more ducts (136, 140) to the at least one outlet from which the air is discharged to flow along at least one surface of the mobile device.

10. The wireless charging module of any one of the preceding claims, wherein the wireless charging module (100) is configured to, based on one or more predetermined conditions, route air from the cool air supply through the one or more ducts (136, 140) to the at least one outlet from which the air is discharged to flow along at least one surface of a mobile device that has been placed along the upper housing portion (104) for wireless charging, and wherein the one or more predetermined conditions include:
an excess temperature alert received from the mobile device; and/or
a determination that additional cooling is desirable based on an amount of power being provided to a receive coil of the mobile device.

11. The wireless charging module of any one of the preceding claims, wherein:
the upper and lower housing portions (104, 108) are configured to be coupled together such that an interior compartment for the at least one coil module (112, 116) is cooperatively defined between the upper and lower housing portions (104, 108) and such that the one or more ducts (136, 140) are disposed generally around a least a portion of the at least one coil module (112, 116); and/or
the wireless charging module (100) further comprises a substrate (164) between the at least one coil module (112, 116) and the upper housing portion (104), wherein the substrate (164) includes at least one aperture (168, 172) aligned with the at least one vent (120, 124) of the upper housing portion (104) to thereby allow the at least one vent of the upper housing portion (104) to communicate with the one or more ducts (136, 140) via the at least one aperture (168, 172) without obstruction from the substrate (164).

12. The wireless charging module of any one of the preceding claims, wherein:
the at least one vent (120, 124) of the upper housing portion (104) comprises at least one outlet (152); and
the one or more ducts (136, 140) comprises at least one side duct in communication with the at least one outlet (152), the at least one side duct is cooperatively defined by an upper channel (156) of the upper housing portion (104) and a lower channel (160) of the lower housing portion (108); and/or
the wireless charging module (100) further comprises a substrate (164) between the at least one coil module (112, 116) and the upper housing portion (104), the substrate (164) includes at least one slot (168) aligned with the upper channel (156) and the lower channel (160) such that the substrate (164) does not obstruct the at least one side duct, whereby air is routable through the at least one side duct to the at least one outlet (152) from which the air is dischargeable to thereafter flow along at least one surface of a mobile device that has been placed along the upper housing portion (104) for wireless charging;

13. The wireless charging module of any one of the preceding claims, wherein:
the housing (104, 108) is configured to support first and second coil modules (112, 116) therein that are operable for respectively charging first and second mobile devices when placed along the upper housing portion (104) respectively above the first and second coil modules (112, 116);
the one or more ducts (136, 140) comprises at least one side duct substantially centrally positioned along the upper housing portion (104) above the first and second coil modules (112, 116); and
the at least one vent (120, 124) of the upper housing portion (104) comprises first and second outlets (152) in communication with the at least one side duct;
whereby air is routable through the at least one side duct to the first and second outlets (152) from which the air is dischargeable to thereafter flow along surfaces of the respective first and second mobile devices that have been between placed along the upper housing portion (104) respectively above the first and second coil modules (112, 116) and along opposite first and second sides of the at least one side duct.

14. The wireless charging module of any one of the preceding claims, wherein:
the housing (104, 108) is configured to support first and second coil modules (112, 116) therein that are operable for respectively charging first and second mobile devices when placed along the upper housing portion (104) respectively above the first and second coil modules (112, 116);
the one or more ducts (136, 140) comprises:
first and second air ducts defined generally around and/or adjacent at least a portion of the first coil module supported within the housing; and
third and fourth air ducts defined generally around and/or adjacent at least a portion of the second coil module supported within the housing;
the at least one vent of the upper housing portion comprises:
first and second air inlets spaced apart along the upper housing portion so as to be adjacent opposite end portions of the first mobile device when the first mobile device is placed along the upper housing portion above the first coil module; and
third and fourth air inlets spaced apart along the upper housing portion so as to be adjacent opposite end portions of the second mobile device when the second mobile device is placed along the upper housing portion above the second coil module;
the at least one vent of the lower housing portion (108) comprises:
a first air outlet in communication with the first and second air inlets via the respective first and second air ducts;
a second air outlet in communication with the third and fourth air inlets via the respective third and fourth air ducts;
the wireless charging module further comprises:
a first fan (148) in communication with the first and second air ducts via the first air outlet of the bottom housing portion, the first fan configured to be operable for generating an air flow into the first and second air inlets of the upper housing portion through the first and second air ducts generally around and/or adjacent the at least a portion of the first coil module supported within the housing to the first air outlet of the lower housing portion (108); and
a second fan (148) in communication with the third and fourth air ducts via the second air outlet of the bottom housing portion, the second fan configured to be operable for generating an air flow into the third and fourth air inlets of the upper housing portion through the third and fourth air ducts generally around and/or adjacent the at least a portion of the second coil module supported within the housing to the second air outlet of the lower housing portion (108).

## Patentansprüche

1. Drahtloses Lademodul, umfassend:
ein Gehäuse (104, 108), das konfiguriert ist, um mindestens ein Spulenmodul (112, 116) in seinem Inneren zu unterstützen, wobei das Gehäuse einen oberen Gehäuseteil (104) und einen unteren Gehäuseteil (108) einschließt, wobei der obere Gehäuseteil (104) mindestens eine Entlüftungsöffnung (120, 124) und der untere Gehäuseteil (108) mindestens eine Entlüftungsöffnung (128, 132) einschließt; und
einen oder mehrere Kanäle (136, 140), die innerhalb des Gehäuses (104, 108) bereitgestellt sind und mit der mindestens einen Entlüftungsöffnung (120, 124) des oberen Gehäuseteils (104) sowie der mindestens einen Entlüftungsöffnung (128, 132) des unteren Gehäuseteils (108) in Verbindung stehen, wodurch ein Strömungspfad von der mindestens einen Entlüftungsöffnung (120, 124) des oberen Gehäuseteils (104) durch den einen oder die mehreren Kanäle (136, 140) zu der mindestens einen Entlüftungsöffnung (128, 132) des unteren Gehäuseteils (108) gebildet wird, um eine Luftströmung im Inneren des Gehäuses (104, 108) zu ermöglichen, im Allgemeinen um mindestens einen Abschnitt des mindestens einen im Gehäuse (104, 108) gelagerten Spulenmoduls (112, 116) herum und/oder benachbart davon,
wobei die mindestens eine Entlüftungsöffnung (120, 124) des oberen Gehäuseteils (104) mindestens einen Auslass umfasst, der so konfiguriert ist, dass er wahlweise über den einen oder die mehreren Kanäle (136, 140) selektiv mit einer Kaltluftzufuhr in Verbindung gebracht werden kann, wodurch Luft aus der Kühlluftzufuhr durch den einen oder die mehreren Kanäle (136, 140) zu dem mindestens einen Auslass des oberen Gehäuseteils geleitet werden kann, aus dem die Luft austreten kann, um anschließend entlang mindestens einer Oberfläche einer mobilen Vorrichtung zu strömen, die entlang des oberen Gehäuseteils (104) platziert wurde, um drahtlos geladen zu werden, und
wobei der mindestens eine Auslass über den einen oder die mehreren Kanäle (136, 140) mit mindestens einem Ventil (176) in Verbindung steht, wobei das mindestens eine Ventil (176) konfiguriert ist, um dem mindestens einen Auslass wahlweisen Zugang zur Kühlluftzufuhr bereitzustellen.

2. Drahtloses Lademodul nach Anspruch 1, wobei der obere Gehäuseteil (104) eine Vielzahl von nach oben ragenden Abschnitten (148) einschließt, die entlang des oberen Gehäuseteils (104) voneinander beabstandet sind, wobei die nach oben ragenden Abschnitte (148) so konfiguriert sind, dass Luft unter einer mobilen Vorrichtung hindurchströmen kann, die auf den nach oben ragenden Abschnitten (148) platziert wurde, um sie drahtlos zu laden.

3. Drahtloses Lademodul nach Anspruch 1 oder 2, ferner umfassend mindestens einen Lüfter (144), der über die mindestens eine Entlüftungsöffnung (128, 132) des unteren Gehäuseteils (108) mit dem einen oder den mehreren Kanälen (136, 140) in Verbindung steht, wobei der mindestens eine Lüfter (144) konfiguriert ist, um betriebsfähig zu sein, um einen Luftstrom in die mindestens eine Öffnung (120, 124) des oberen Gehäuseteils (104) durch die einen oder mehrere Kanäle (136, 140) zu der mindestens einen Öffnung (128, 132) des unteren Gehäuseteils (108) zu erzeugen.

4. Drahtloses Lademodul nach einem der Ansprüche 1 bis 3, wobei:
der eine oder die mehreren Kanäle (136, 140) eine Vielzahl von Kanälen umfassen, die innerhalb des Gehäuses bereitgestellt sind;
die mindestens eine Entlüftungsöffnung (120, 124) des oberen Gehäuseteils (104) eine erste und eine zweite Entlüftungsöffnung umfasst, die mit der Vielzahl von Kanälen (136, 140) in Verbindung stehen; und
die erste und die zweite Entlüftungsöffnung entlang des oberen Gehäuseteils (104) voneinander beabstandet sind, sodass sie jeweils an den gegenüberliegenden ersten und zweiten Endabschnitten einer mobilen Vorrichtung angrenzen, wenn die mobile Vorrichtung zum drahtlosen Laden entlang des oberen Gehäuseteils (104) platziert wird.

5. Drahtloses Lademodul nach einem der vorstehenden Ansprüche, wobei:
der obere Gehäuseteil (104) eine Vielzahl von Rippen einschließt, die entlang des oberen Gehäuseteils (104) beabstandet angeordnet sind und von diesem nach oben vorstehen;
die mindestens eine Entlüftungsöffnung des unteren Gehäuseteils (108) mindestens einen Luftauslass (128, 132) umfasst;
die mindestens eine Entlüftungsöffnung des oberen Gehäuseteils (104) einen ersten und einen zweiten Lufteinlass (120, 124) umfasst, die mit dem einen oder den mehreren Kanälen (136, 140) in Verbindung stehen, wobei der erste und der zweite Lufteinlass (120, 124) entlang des oberen Gehäuseteils (104) so voneinander beabstandet sind, dass sie jeweils an den gegenüberliegenden ersten und zweiten Endabschnitten einer mobilen Vorrichtung angrenzen, die auf den Rippen zum drahtlosen Laden platziert wurde; und
die Rippen so konfiguriert sind, dass Luft unter der mobilen Vorrichtung hindurchströmen und anschließend durch den einen oder die mehreren Kanäle (136, 140) in den ersten und zweiten Lufteinlass (120, 124) zum mindestens einen Luftauslass (128, 132) des unteren Gehäuseteils (108) gesaugt werden kann

6. Drahtloses Lademodul nach Anspruch 5, wobei:
das drahtlose Lademodul (100) ferner mindestens einen Lüfter (148) umfasst, der über den mindestens einen Luftauslass (128, 132) des unteren Gehäuseteils (108) mit dem einen oder den mehreren Kanälen (136, 140) in Verbindung steht; und
der mindestens eine Lüfter (148) so konfiguriert ist, dass er betriebsfähig ist, um Luft von der Unterseite der mobilen Vorrichtung zwischen Paaren benachbarter Rippen hindurch in den ersten und zweiten Lufteinlass (120, 124) über den einen oder die mehreren Kanäle (136, 140) zu dem mindestens einen Luftauslass (128, 132) des unteren Gehäuseteils (108) zu saugen.

7. Drahtloses Lademodul nach Anspruch 1, wobei:
die mindestens eine Entlüftungsöffnung des oberen Gehäuseteils (104) ferner mindestens einen Einlass stromabwärts von dem mindestens einen Auslass umfasst, wobei der mindestens eine Einlass konfiguriert ist, um Luft aufzunehmen, die aus dem mindestens einen Auslass abgegeben wird, nachdem sie entlang der mindestens einen Oberfläche der mobilen Vorrichtung geströmt ist; und
das drahtlose Lademodul (100) ferner mindestens einen Lüfter (148) umfasst, der über den einen oder die mehreren Kanäle (136, 140) mit dem mindestens einen Einlass in Verbindung steht, wobei der mindestens eine Lüfter (148) so konfiguriert ist, dass er betriebsfähig ist, um Luft in den mindestens einen Einlass anzusaugen oder zu ziehen.

8. Drahtloses Lademodul nach einem der vorstehenden Ansprüche, wobei:
das drahtlose Lademodul (100) so konfiguriert ist, dass der mindestens eine Auslass wahlweise mit einer Klimaanlage eines Fahrzeugs in Verbindung stehen kann, in dem das drahtlose Lademodul (100) verwendet wird; und/oder
die Kaltluftzufuhr mindestens einen Lüfter (148) umfasst, der über den einen oder die mehreren Kanäle (136, 140) mit dem mindestens einen Auslass in Verbindung steht.

9. Drahtloses Lademodul nach einem der vorstehenden Ansprüche, wobei:
das drahtlose Lademodul (100) ferner mindestens einen Temperatursensor umfasst, der so konfiguriert ist, dass er zur Bestimmung der Temperatur der mobilen Vorrichtung betriebsfähig ist, die zum drahtlosen Laden entlang des oberen Gehäuseteils (104) platziert wurde; und/oder
das drahtlose Lademodul (100) zu Folgendem konfiguriert ist:
Bestimmen, ob sich die Temperatur der mobilen Vorrichtung erhöht und eine zusätzliche Kühlung erforderlich ist; und
als Reaktion auf das Bestimmen, dass die sich die Temperatur der mobilen Vorrichtung erhöht und eine zusätzliche Kühlung erforderlich ist, Leiten von Luft aus der Kaltluftzufuhr durch den einen oder die mehrere Kanäle (136, 140) zu dem mindestens einen Auslass , aus dem die Luft abgegeben wird, um entlang mindestens einer Oberfläche der mobilen Vorrichtung zu strömen.

10. Drahtloses Lademodul nach einem der vorstehenden Ansprüche, wobei das drahtlose Lademodul (100) so konfiguriert ist, dass es basierend auf einer oder mehreren vorbestimmten Bedingungen Luft aus der Kaltluftzufuhr durch den einen oder die n Kanäle (136, 140) zu dem mindestens einen Auslass leitet, aus dem die Luft abgegeben wird, um entlang mindestens einer Oberfläche einer mobilen Vorrichtung zu strömen, die entlang des oberen Gehäuseteils (104) platziert wurde, für das drahtlose Laden, und wobei die eine oder mehreren vorgegebenen Bedingungen Folgendes einschließen:
eine von der mobilen Vorrichtung empfangene Warnmeldung wegen Übertemperatur; und/oder
eine Bestimmung, dass eine zusätzliche Kühlung wünschenswert ist, basierend auf einer Leistungsmenge, die einer Empfangsspule der mobilen Vorrichtung zugeführt wird.

11. Drahtloses Lademodul nach einem der vorstehenden Ansprüche, wobei:
der obere und der untere Gehäuseteil (104, 108) so konfiguriert sind, dass sie miteinander verbunden werden können, sodass ein Innenraum für das mindestens eine Spulenmodul (112, 116) gemeinsam zwischen dem oberen und dem unteren Gehäuseteil (104, 108) gebildet wird, und dass der eine oder die mehreren Kanäle (136, 140) im Wesentlichen um mindestens einen Abschnitt des mindestens einen Spulenmoduls (112, 116) angeordnet sind; und/oder
das drahtlose Lademodul (100) ferner ein Substrat (164) zwischen dem mindestens einen Spulenmodul (112, 116) und dem oberen Gehäuseteil (104) umfasst, wobei das Substrat (164) mindestens eine Öffnung (168, 172) einschließt, die auf die mindestens eine Entlüftungsöffnung (120, 124) des oberen Gehäuseteils (104) ausgerichtet ist, wodurch es ermöglicht wird, dass die mindestens eine Entlüftungsöffnung des oberen Gehäuseteils (104) über die mindestens eine Öffnung (168, 172) ohne Behinderung durch das Substrat (164) mit dem einen oder den mehreren Kanälen (136, 140) in Verbindung steht.

12. Drahtloses Lademodul nach einem der vorstehenden Ansprüche, wobei:
die mindestens eine Entlüftungsöffnung (120, 124) des oberen Gehäuseteils (104) mindestens einen Auslass (152) umfasst; und
der eine oder die mehreren Kanäle (136, 140) mindestens einen Seitenkanal umfassen, der mit dem mindestens einen Auslass (152) in Verbindung steht, wobei der mindestens eine Seitenkanal gemeinsam durch einen oberen Kanal (156) des oberen Gehäuseteils (104) und einen unteren Kanal (160) des unteren Gehäuseteils (108) gebildet wird; und/oder
das drahtlose Lademodul (100) ferner ein Substrat (164) zwischen dem mindestens einen Spulenmodul (112, 116) und dem oberen Gehäuseteil (104) umfasst, wobei das Substrat (164) mindestens einen Slot (168) einschließt, der auf den oberen Kanal (156) und den unteren Kanal (160) ausgerichtet ist, derart, dass das Substrat (164) den mindestens einen Seitenkanal nicht versperrt, wodurch Luft durch den mindestens einen Seitenkanal zu dem mindestens einen Auslass (152) geleitet werden kann, aus dem die Luft austreten kann, um anschließend entlang mindestens einer Oberfläche einer mobilen Vorrichtung zu strömen, die entlang des oberen Gehäuseteils (104) zum drahtlosen Laden platziert wurde;

13. Drahtloses Lademodul nach einem der vorstehenden Ansprüche, wobei:
das Gehäuse (104, 108) so konfiguriert ist, dass es darin ein erstes und ein zweites Spulenmodul (112, 116) aufnimmt, die betriebsfähig sind, um eine erste bzw. eine zweite mobile Vorrichtung aufzuladen, wenn diese entlang des oberen Gehäuseteils (104) jeweils über dem ersten bzw. dem zweiten Spulenmodul (112, 116) platziert werden;
der eine oder die mehreren Kanäle (136, 140) mindestens einen Seitenkanal umfassen, der im Wesentlichen mittig entlang des oberen Gehäuseteils (104) über dem ersten und zweiten Spulenmodul (112, 116) positioniert ist; und
die mindestens eine Entlüftungsöffnung (120, 124) des oberen Gehäuseteils (104) einen ersten und einen zweiten Auslass (152) umfasst, die mit dem mindestens einen Seitenkanal in Verbindung stehen;
wodurch Luft durch den mindestens einen Seitenkanal zum ersten und zweiten Auslass (152) geleitet werden kann, aus denen die Luft austreten kann, um anschließend entlang der Oberflächen der jeweiligen ersten und zweiten mobilen Vorrichtung zu strömen, die entlang des oberen Gehäuseteils (104) jeweils über dem ersten und zweiten Spulenmodul (112, 116) und entlang der gegenüberliegenden ersten und zweiten Seite des mindestens einen Seitenkanals platziert wurden.

14. Drahtloses Lademodul nach einem der vorstehenden Ansprüche, wobei:
das Gehäuse (104, 108) so konfiguriert ist, dass es darin ein erstes und ein zweites Spulenmodul (112, 116) aufnimmt, die betriebsfähig sind, um eine erste bzw. eine zweite mobile Vorrichtung aufzuladen, wenn diese entlang des oberen Gehäuseteils (104) jeweils über dem ersten bzw. dem zweiten Spulenmodul (112, 116) platziert werden;
der eine oder die mehreren Kanäle (136, 140) Folgendes umfassen:
einen ersten und einen zweiten Luftkanal, die im Wesentlichen um mindestens einen Abschnitt des ersten, im Gehäuse unterstützten Spulenmoduls herum und/oder benachbart davon gebildet sind; und
einen dritten und einen vierten Luftkanal, die im Wesentlichen um mindestens einen Abschnitt des zweiten, im Gehäuse unterstützten Spulenmoduls herum und/oder benachbart davon gebildet sind;
wobei die mindestens eine Entlüftungsöffnung des oberen Gehäuseteils Folgendes umfasst:
einen ersten und einen zweiten Lufteinlass, die entlang des oberen Gehäuseteils so beabstandet sind, dass sie an gegenüberliegende Endabschnitte der ersten mobilen Vorrichtung angrenzen, wenn die erste mobile Vorrichtung entlang des oberen Gehäuseteils über dem ersten Spulenmodul platziert wird; und
einen dritten und einen vierten Lufteinlass, die entlang des oberen Gehäuseteils so beabstandet sind, dass sie an gegenüberliegende Endabschnitte der zweiten mobilen Vorrichtung angrenzen, wenn die zweite mobile Vorrichtung entlang des oberen Gehäuseteils über dem zweiten Spulenmodul platziert wird;
die mindestens eine Entlüftungsöffnung des unteren Gehäuseteils (108) Folgendes umfasst:
einen ersten Luftauslass, der über den jeweiligen ersten und zweiten Luftkanal mit dem ersten und zweiten Lufteinlass in Verbindung steht;
einen zweiten Luftauslass, der über den jeweiligen dritten und vierten Luftkanal mit dem dritten und vierten Lufteinlass in Verbindung steht;
das drahtlose Lademodul ferner Folgendes umfasst:
einen ersten Lüfter (148), der über den ersten Luftauslass des unteren Gehäuseteils mit dem ersten und dem zweiten Luftkanal in Verbindung steht, wobei der erste Lüfter so konfiguriert ist, dass er betriebsfähig ist, um einen Luftstrom in den ersten und zweiten Lufteinlass des oberen Gehäuses durch den ersten und zweiten Luftkanal im Wesentlichen um den mindestens einen Teil des im Gehäuse gelagerten ersten Spulenmoduls herum und/oder benachbart davon bis zum ersten Luftauslass des unteren Gehäuses (108) zu erzeugen; sowie
einen zweiten Lüfter (148), der über den zweiten Luftauslass des unteren Gehäuseteils mit dem dritten und vierten Luftkanal in Verbindung steht, wobei der zweite Lüfter so konfiguriert ist, dass er betriebsfähig ist, um einen Luftstrom in den dritten und vierten Lufteinlasse des oberen Gehäuseteils durch den dritten und vierten Luftkanal im Wesentlichen um den mindestens einen Teil des zweiten, im Gehäuse gelagerten Spulenmoduls herum und/oder benachbart davon bis zum zweiten Luftauslass des unteren Gehäuseteils (108) zu erzeugen.

## Revendications

1. Module de charge sans fil comprenant :
un boîtier (104, 108) conçu pour supporter au moins un module de bobine (112, 116) en son sein, le boîtier comportant une partie de boîtier supérieure (104) et une partie de boîtier inférieure (108), la partie de boîtier supérieure (104) comportant au moins un évent (120, 124), la partie de boîtier inférieure (108) comportant au moins un évent (128, 132) ; et
un ou plusieurs conduits (136, 140) fournis au sein du boîtier (104, 108) et en communication avec l'au moins un évent (120, 124) de la partie de boîtier supérieure (104) et l'au moins un évent (128, 132) de la partie de boîtier inférieure (108), moyennant quoi un chemin d'écoulement d'air est défini depuis l'au moins un évent (120, 124) de la partie de boîtier supérieure (104) à travers le ou les conduits (136, 140) jusqu'à l'au moins un évent (128, 132) de la partie de boîtier inférieure (108) pour permettre un écoulement d'air en interne au sein du boîtier (104, 108) généralement autour et/ou à proximité d'au moins une partie de l'au moins un module de bobine (112, 116) supporté au sein du boîtier (104, 108),
dans lequel l'au moins un évent (120, 124) de la partie de boîtier supérieure (104) comprend au moins une sortie conçue pour être sélectivement en communication avec une alimentation en air frais par l'intermédiaire du ou des conduits (136, 140), moyennant quoi l'air provenant de l'alimentation en air frais peut être acheminé à travers le ou les conduits (136, 140) vers l'au moins une sortie de la partie de boîtier supérieure, d'où l'air peut être évacué pour ensuite s'écouler le long d'au moins une surface d'un dispositif mobile qui a été placé le long de la partie de boîtier supérieure (104) pour une charge sans fil, et
dans lequel l'au moins une sortie est en communication avec au moins une vanne (176) par l'intermédiaire du ou des conduits (136, 140), l'au moins une vanne (176) étant conçue pour fournir à l'au moins une sortie un accès sélectif à l'alimentation en air frais.

2. Module de charge sans fil selon la revendication 1, dans lequel la partie de boîtier supérieure (104) comporte une pluralité de parties saillantes vers le haut (148) espacées le long de la partie de boîtier supérieure (104), moyennant quoi les parties saillantes vers le haut (148) sont conçues pour permettre à l'air de passer sous un dispositif mobile qui a été placé au-dessus des parties saillantes vers le haut (148) pour une charge sans fil.

3. Module de charge sans fil selon la revendication 1 ou 2, comprenant en outre au moins un ventilateur (144) en communication avec le ou les conduits (136, 140) par l'intermédiaire de l'au moins un évent (128, 132) de la partie de boîtier inférieure (108), l'au moins un ventilateur (144) étant conçu pour pouvoir fonctionner afin de générer un écoulement d'air dans l'au moins un évent (120, 124) de la partie de boîtier supérieure (104) à travers le ou les conduits (136, 140) jusqu'à l'au moins un évent (128, 132) de la partie de boîtier inférieure (108).

4. Module de charge sans fil selon l'une quelconque des revendications 1 à 3, dans lequel :
le ou les conduits (136, 140) comprennent une pluralité de conduits fournis au sein du boîtier ;
l'au moins un évent (120, 124) de la partie de boîtier supérieure (104) comprend des premier et second évents en communication avec la pluralité de conduits (136, 140) ; et
les premier et second évents sont espacés l'un de l'autre le long de la partie de boîtier supérieure (104) de manière à être respectivement adjacents à des première et seconde parties d'extrémité opposées d'un dispositif mobile lorsque le dispositif mobile est placé le long de la partie de boîtier supérieure (104) pour une charge sans fil.

5. Module de charge sans fil selon l'une quelconque des revendications précédentes, dans lequel :
la partie de boîtier supérieure (104) comporte une pluralité de nervures espacées le long de la partie de boîtier supérieure (104) et faisant saillie vers le haut à partir de celle-ci ;
l'au moins un évent de la partie de boîtier inférieure (108) comprend au moins une sortie d'air (128, 132) ;
l'au moins un évent de la partie de boîtier supérieure (104) comprend des première et deuxième entrées d'air (120, 124) en communication avec le ou les conduits (136, 140), les première et deuxième entrées d'air (120, 124) étant espacées l'une de l'autre le long de la partie de boîtier supérieure (104) de manière à être respectivement adjacentes aux première et seconde parties d'extrémité opposées d'un dispositif mobile qui a été placé au-dessus des nervures pour une charge sans fil ; et
les nervures sont conçues pour permettre à l'air de passer au-dessous du dispositif mobile puis d'être aspiré dans les première et deuxième entrées d'air (120, 124) à travers le ou les conduits (136, 140) vers l'au moins une sortie d'air (128, 132) de la partie de boîtier inférieure (108).

6. Module de charge sans fil selon la revendication 5, dans lequel :
le module de charge sans fil (100) comprend en outre au moins un ventilateur (148) en communication avec le ou les conduits (136, 140) par l'intermédiaire de l'au moins une sortie d'air (128, 132) de la partie de boîtier inférieure (108) ; et
l'au moins un ventilateur (148) est conçu pour pouvoir fonctionner pour aspirer l'air depuis au-dessous du dispositif mobile entre des paires de nervures adjacentes dans les première et deuxième entrées d'air (120, 124) à travers le ou les conduits (136, 140) vers l'au moins une sortie d'air (128, 132) de la partie de boîtier inférieure (108).

7. Module de charge sans fil selon la revendication 1, dans lequel :
l'au moins un évent de la partie de boîtier supérieure (104) comprend en outre au moins une entrée en aval de l'au moins une sortie, moyennant quoi l'au moins une entrée est conçue pour recevoir l'air évacué de l'au moins une sortie après s'être écoulé le long de l'au moins une surface du dispositif mobile ; et
le module de charge sans fil (100) comprend en outre au moins un ventilateur (148) en communication avec l'au moins une entrée par l'intermédiaire du ou des conduits (136, 140), moyennant quoi l'au moins un ventilateur (148) est conçu pour pouvoir fonctionner afin d'aspirer ou d'attirer l'air dans l'au moins une entrée.

8. Module de charge sans fil selon l'une quelconque des revendications précédentes, dans lequel :
le module de charge sans fil (100) est conçu pour permettre à l'au moins une sortie d'être sélectivement en communication avec un système de climatisation d'un véhicule dans lequel le module de charge sans fil (100) est utilisé ; et/ou
l'alimentation en air frais comprend au moins un ventilateur (148) en communication avec l'au moins une sortie par l'intermédiaire du ou des conduits (136, 140).

9. Module de charge sans fil selon l'une quelconque des revendications précédentes, dans lequel :
le module de charge sans fil (100) comprend en outre au moins un capteur de température conçu pour pouvoir fonctionner afin de déterminer une température du dispositif mobile qui a été placé le long de la partie de boîtier supérieure (104) pour une charge sans fil ; et/ou
le module de charge sans fil (100) est conçu pour :
déterminer si la température du dispositif mobile augmente et nécessite un refroidissement supplémentaire ; et
en réponse à la détermination que le dispositif mobile augmente et nécessite un refroidissement supplémentaire, acheminer l'air de l'alimentation en air frais à travers le ou les conduits (136, 140) vers l'au moins une sortie à partir de laquelle l'air est évacué pour s'écouler le long d'au moins une surface du dispositif mobile.

10. Module de charge sans fil selon l'une quelconque des revendications précédentes, dans lequel le module de charge sans fil (100) est conçu pour, en fonction d'une ou plusieurs conditions prédéterminées, acheminer l'air provenant de l'alimentation en air frais à travers le ou les conduits (136, 140) vers l'au moins une sortie à partir de laquelle l'air est évacué pour s'écouler le long d'au moins une surface d'un dispositif mobile qui a été placé le long de la partie de boîtier supérieure (104) pour une charge sans fil, et dans lequel la ou les conditions prédéterminées comportent :
une alerte de température excessive reçue du dispositif mobile ; et/ou
une détermination selon laquelle un refroidissement supplémentaire est souhaitable en fonction d'une quantité de puissance fournie à une bobine de réception du dispositif mobile.

11. Module de charge sans fil selon l'une quelconque des revendications précédentes, dans lequel :
les parties de boîtier supérieure et inférieure (104, 108) sont conçues pour être accouplées ensemble, de telle sorte qu'un compartiment intérieur pour l'au moins un module de bobine (112, 116) est défini de manière coopérative entre les parties de boîtier supérieure et inférieure (104, 108) et de telle sorte que le ou les conduits (136, 140) sont disposés généralement autour d'au moins une partie de l'au moins un module de bobine (112, 116) ; et/ou
le module de charge sans fil (100) comprend en outre un substrat (164) entre l'au moins un module de bobine (112, 116) et la partie de boîtier supérieure (104), dans lequel le substrat (164) comporte au moins une ouverture (168, 172) alignée avec l'au moins un évent (120, 124) de la partie de boîtier supérieure (104) pour permettre de ce fait à l'au moins un évent de la partie de boîtier supérieure (104) de communiquer avec le ou les conduits (136, 140) par l'intermédiaire de l'au moins une ouverture (168, 172) sans obstruction du substrat (164).

12. Module de charge sans fil selon l'une quelconque des revendications précédentes, dans lequel :
l'au moins un évent (120, 124) de la partie de boîtier supérieure (104) comprend au moins une sortie (152) ; et
le ou les conduits (136, 140) comprennent au moins un conduit latéral en communication avec l'au moins une sortie (152), l'au moins un conduit latéral est défini de manière coopérative par un canal supérieur (156) de la partie de boîtier supérieure (104) et un canal inférieur (160) de la partie de boîtier inférieure (108) ; et/ou
le module de charge sans fil (100) comprend en outre un substrat (164) entre l'au moins un module de bobine (112, 116) et la partie de boîtier supérieure (104), le substrat (164) comporte au moins une fente (168) alignée avec le canal supérieur (156) et le canal inférieur (160), de telle sorte que le substrat (164) n'obstrue pas l'au moins un conduit latéral, moyennant quoi l'air peut être acheminé à travers l'au moins un conduit latéral vers l'au moins une sortie (152) d'où l'air peut être évacué pour ensuite s'écouler le long d'au moins une surface d'un dispositif mobile qui a été placé le long de la partie de boîtier supérieure (104) pour une charge sans fil ;

13. Module de charge sans fil selon l'une quelconque des revendications précédentes, dans lequel :
le boîtier (104, 108) est conçu pour supporter des premier et second modules de bobine (112, 116) en son sein, lesquels peuvent fonctionner pour respectivement charger des premier et second dispositifs mobiles lorsqu'ils sont placés le long de la partie de boîtier supérieure (104) respectivement au-dessus des premier et second modules de bobine (112, 116) ;
le ou les conduits (136, 140) comprennent au moins un conduit latéral positionné sensiblement au centre le long de la partie de boîtier supérieure (104) au-dessus des premier et second modules de bobine (112, 116) ; et
l'au moins un évent (120, 124) de la partie de boîtier supérieure (104) comprend des première et seconde sorties (152) en communication avec l'au moins un conduit latéral ;
moyennant quoi l'air peut être acheminé à travers l'au moins un conduit latéral vers les première et seconde sorties (152) d'où l'air peut être évacué pour ensuite s'écouler le long de surfaces des premier et second dispositifs mobiles respectifs qui ont été placés de façon intermédiaire le long de la partie de boîtier supérieure (104) respectivement au-dessus des premier et second modules de bobine (112, 116) et le long de premier et second côtés opposés de l'au moins un conduit latéral.

14. Module de charge sans fil selon l'une quelconque des revendications précédentes, dans lequel :
le boîtier (104, 108) est conçu pour supporter des premier et second modules de bobine (112, 116) en son sein, lesquels peuvent fonctionner pour respectivement charger des premier et second dispositifs mobiles lorsqu'ils sont placés le long de la partie de boîtier supérieure (104) respectivement au-dessus des premier et second modules de bobine (112, 116) ;
le ou les conduits (136, 140) comprennent :
des premier et deuxième conduits d'air définis généralement autour et/ou à proximité d'au moins une partie du premier module de bobine supporté au sein du boîtier ; et
des troisième et quatrième conduits d'air définis généralement autour et/ou à proximité d'au moins une partie du second module de bobine supporté au sein du boîtier ;
l'au moins un évent de la partie de boîtier supérieure comprend :
des première et deuxième entrées d'air espacées le long de la partie de boîtier supérieure de manière à être adjacentes à des parties d'extrémité opposées du premier dispositif mobile lorsque le premier dispositif mobile est placé le long de la partie de boîtier supérieure au-dessus du premier module de bobine ; et
des troisième et quatrième entrées d'air espacées le long de la partie de boîtier supérieure de manière à être adjacentes à des parties d'extrémité opposées du second dispositif mobile lorsque le second dispositif mobile est placé le long de la partie de boîtier supérieure au-dessus du second module de bobine ;
l'au moins un évent de la partie de boîtier inférieure (108) comprend :
une première sortie d'air en communication avec les première et deuxième entrées d'air par l'intermédiaire des premier et deuxième conduits d'air respectifs ;
une seconde sortie d'air en communication avec les troisième et quatrième entrées d'air par l'intermédiaire des troisième et quatrième conduits d'air respectifs ;
le module de charge sans fil comprend en outre :
un premier ventilateur (148) en communication avec les premier et deuxième conduits d'air par l'intermédiaire de la première sortie d'air de la partie de boîtier inférieure, le premier ventilateur étant conçu pour pouvoir fonctionner afin de générer un écoulement d'air dans les première et deuxième entrées d'air de la partie de boîtier supérieure à travers les premier et deuxième conduits d'air généralement autour et/ou à proximité de l'au moins une partie du premier module de bobine supporté au sein du boîtier jusqu'à la première sortie d'air de la partie de boîtier inférieure (108) ; et
un second ventilateur (148) en communication avec les troisième et quatrième conduits d'air par l'intermédiaire de la seconde sortie d'air de la partie de boîtier inférieure, le second ventilateur étant conçu pour pouvoir fonctionner afin de générer un écoulement d'air dans les troisième et quatrième entrées d'air de la partie de boîtier supérieure à travers les troisième et quatrième conduits d'air généralement autour et/ou à proximité de l'au moins une partie du second module de bobine supporté au sein du boîtier jusqu'à la seconde sortie d'air de la partie de boîtier inférieure (108).
